# FASCICULE DE BREVET EUROPEEN

(11) **EP 4 199 284 B1**
(45) Date de publication et mention de la délivrance du brevet: **03.07.2024**
(21) Numéro de dépôt: 22213195.5
(22) Date de dépôt: 13.12.2022
(51) Int. Cl.: H02H 1/00, G01R 31/52, H02H 3/093

(54) **PROCÉDÉS POUR DÉTECTER UN DÉFAUT ÉLECTRIQUE, SYSTÈMES DE PROTECTION ÉLECTRIQUE ASSOCIÉS**
VERFAHREN ZUR ERKENNUNG EINES ELEKTRISCHEN FEHLERS, ZUGEHÖRIGE ELEKTRISCHE SCHUTZSYSTEME
METHODS FOR DETECTING AN ELECTRICAL FAULT, ASSOCIATED ELECTRICAL PROTECTION SYSTEMS

(30) Priorité: 14.12.2021 FR 2113499
(43) Date de publication de la demande: 21.06.2023
(73) Titulaire: SCHNEIDER ELECTRIC INDUSTRIES SAS, 92500 Rueil-Malmaison (FR)
(72) Inventeur: GONZALEZ, Daniel, 38420 DOMENE (FR)
(74) Mandataire: Lavoix

(56) Documents cités:
- US-A1- 2015 070 026
- US-A1- 2020 105 490
- US-A1- 2020 355 745

## Description

La présente invention concerne des procédés de détection d'un défaut électrique, ainsi que des systèmes de protection électrique pour implémenter de tels procédés.

L'invention concerne plus généralement le domaine de la protection électrique dans des installations de distribution d'électricité.

Il est depuis longtemps connu d'utiliser des appareils de protection électrique, tels que des disjoncteurs, qui permettent d'interrompre l'alimentation électrique d'une charge électrique ou d'une installation électrique en cas d'apparition d'un défaut électrique, tel qu'un court-circuit. Ces appareils de protection permettent aussi, en fonction de règles de sélectivité définies à l'échelle de l'installation électrique, d'isoler la partie de l'installation électrique qui est à l'origine du défaut électrique afin de permettre au reste de l'installation électrique de fonctionner normalement.

De tels appareils comportent généralement un déclencheur, dont la fonction est de détecter un défaut électrique, en utilisant des moyens de détection électromécaniques et/ou électroniques, pour détecter lorsque l'amplitude du courant électrique devient trop élevée.

De tels déclencheurs ont pendant longtemps donné satisfaction. Cependant, des évolutions technologiques récentes, telles que celles liées au développement des énergies renouvelables, impliquant l'usage de convertisseurs de puissance, nécessitent de mettre au point des appareils de protection répondant à de nouveaux besoins.

En effet, il est de plus en plus fréquent que des installations électriques locales ou domestiques soient alimentées par des sources électriques photovoltaïques et/ou par des dispositifs de stockage d'électricité capables de fonctionner ponctuellement en tant que générateurs.

De telles sources électriques sont généralement basées sur des convertisseurs de puissance à découpage dont le fonctionnement est assuré par des composants semi-conducteurs de puissance. Mais, du fait de la présence de ces convertisseurs de puissance, ces sources électriques ont un comportement différent de celui des générateurs classiques en cas de défaut électrique.

En particulier, les courants de défaut, notamment les courants de court-circuit, sont beaucoup moins élevés en amplitude que dans les installations traditionnelles, à cause de caractéristiques techniques inhérentes aux composants semi-conducteurs utilisés.

Dans des installations classiques alimentées uniquement par le réseau électrique public (secteur), les courants de court-circuit habituellement rencontrés peuvent présenter des amplitudes élevées, pouvant parfois atteindre jusqu'à plusieurs kilo-ampères (kA), car leur amplitude n'est limitée que par l'impédance du transformateur amont et/ou par l'impédance des câbles de distribution. Au contraire, dans des installations comportant un ou plusieurs convertisseurs à découpage, les amplitudes des courants de défaut sont inférieures, par exemple dix fois moins importantes, ou pire.

Ainsi, dans les installations modernes comportant un ou plusieurs convertisseurs de puissance à découpage, il est plus difficile de détecter des défauts électriques.

Pour pallier à ce problème, dans de telles installations, il est d'usage de réduire le seuil de déclenchement en courant des appareils de protection.

Il est par exemple courant de choisir un seuil de déclenchement cinq fois inférieur au courant maximal que peut délivrer le convertisseur de puissance de la source électrique, afin de laisser une marge de sécurité suffisante pour être certain que les appareils de protection pourront bien détecter un court circuit.

Mais, dans ce cas, les charges électriques ne peuvent alors utiliser qu'une fraction de la puissance électrique que peut théoriquement fournir la source électrique. US2020/105490 et US 2015/070026 décrivent un système de protection pour protéger une installation électrique comportant une source électrique.

C'est à ces inconvénients qu'entend plus particulièrement remédier l'invention en proposant des procédés améliorés pour détecter un défaut électrique dans une installation électrique comportant un convertisseur de puissance à découpage.

A cet effet, un aspect de l'invention concerne un procédé pour détecter un défaut électrique dans une installation électrique, ladite installation électrique comportant une source électrique basée sur un convertisseur de puissance à découpage, le procédé comportant des étapes consistant à :
- mesurer, par un capteur associé à un appareil électrique de protection de l'installation, un courant électrique alternatif circulant dans l'installation électrique ;
- détecter un défaut électrique, tel qu'un court-circuit, à partir du courant électrique mesuré, par un dispositif électronique de commande ;
- déclencher l'appareil de protection électrique lorsqu'un défaut électrique est identifié par le dispositif électronique de commande ;
dans lequel détecter un défaut électrique comporte l'identification d'une transition du courant mesuré depuis un premier niveau vers un deuxième niveau, ladite transition ayant une durée inférieure à un seuil prédéfini, le seuil prédéfini étant inférieur ou égal à 10% de la période nominale du courant électrique alternatif, le premier niveau et le deuxième niveau correspondant à des valeurs de courant de signe opposé mais dont l'amplitude, en valeur absolue, est supérieure à un seuil de courant prédéfini, le seuil de courant prédéfini étant égal au produit du seuil de déclenchement de l'appareil de protection par un coefficient de pondération.

Selon des aspects avantageux mais non obligatoires, un tel procédé peut incorporer une ou plusieurs des caractéristiques suivantes, prises isolément ou suivant toute combinaison techniquement admissible :
- le défaut électrique n'est détecté que si, en plus, ladite transition du courant mesurée est identifiée comme se répétant sur une ou plusieurs périodes du courant alternatif mesuré, sur une durée supérieure ou égale à une durée prédéfinie ;
- la durée prédéfinie est supérieure ou égale à trois fois la période nominale du courant électrique alternatif ;
- le seuil prédéfini étant inférieur ou égal à 10% de la période nominale du courant électrique ;
- le coefficient de pondération est supérieur à 1 ;
- le coefficient de pondération est compris entre 1 et 5 ;
- le courant électrique mesuré est un courant monophasé ou polyphasé, tel qu'un courant triphasé, et un défaut électrique est considéré comme détecté si ladite transition du courant mesuré est identifiée pour au moins une phase électrique du courant mesuré.

Selon un autre aspect, l'invention concerne un système de protection pour protéger une installation électrique comportant une source électrique basée sur un convertisseur de puissance à découpage, le système de protection comportant au moins un appareil de protection électrique et un dispositif électronique de commande programmé pour :
- mesurer, par un capteur associé à un appareil de protection électrique de l'installation, un courant électrique alternatif circulant dans l'installation électrique ;
- détecter un défaut électrique, tel qu'un court-circuit, à partir du courant électrique mesuré ;
- déclencher l'appareil de protection électrique lorsqu'un défaut électrique est identifié ;
dans lequel détecter un défaut électrique comporte l'identification d'une transition du courant mesuré depuis un premier niveau vers un deuxième niveau, ladite transition ayant une durée inférieure à un seuil prédéfini, le seuil prédéfini étant inférieur ou égal à 10% de la période nominale du courant électrique alternatif, le premier niveau et le deuxième niveau correspondant à des valeurs de courant de signe opposé mais dont l'amplitude, en valeur absolue, est supérieure à un seuil de courant prédéfini, le seuil de courant prédéfini étant égal au produit du seuil de déclenchement de l'appareil de protection par un coefficient de pondération.

Selon des aspects avantageux mais non obligatoires, un tel système peut incorporer une ou plusieurs des caractéristiques suivantes, prises isolément ou suivant toute combinaison techniquement admissible :
- un dispositif électronique de commande est associé à chaque appareil de protection électrique ;
- le dispositif électronique de commande est connecté à chaque appareil de protection électrique.

L'invention sera mieux comprise et d'autres avantages de celle-ci apparaîtront plus clairement à la lumière de la description qui va suivre d'un mode de réalisation d'un procédé pour détecter un défaut électrique, donnée uniquement à titre d'exemple et faite en référence aux dessins annexés, dans lesquels :
[Fig 1] la figure 1 est un schéma synoptique d'un exemple d'une installation électrique conforme à l'invention ;
[Fig 2] la figure 2 est un schéma de courbes de déclenchement d'un appareil de protection électrique dans l'installation électrique de la figure 1 ;
[Fig 3] la figure 3 représente l'évolution d'un courant électrique au cours du temps en présence d'un défaut électrique dans une installation électrique pour illustrer une première signature d'un défaut électrique ;
[Fig 4] la figure 4 représente l'évolution d'un courant électrique au cours du temps en présence d'un défaut électrique dans une installation électrique pour illustrer une deuxième signature d'un défaut électrique ;
[Fig 5] la figure 5 représente l'évolution d'une tension électrique et d'un courant électrique au cours du temps comportant une transition non linéaire lors de la connexion d'une charge électrique ;
[Fig 6] la figure 6 est un schéma bloc représentant un exemple d'un procédé pour détecter un défaut électrique conforme à l'invention.

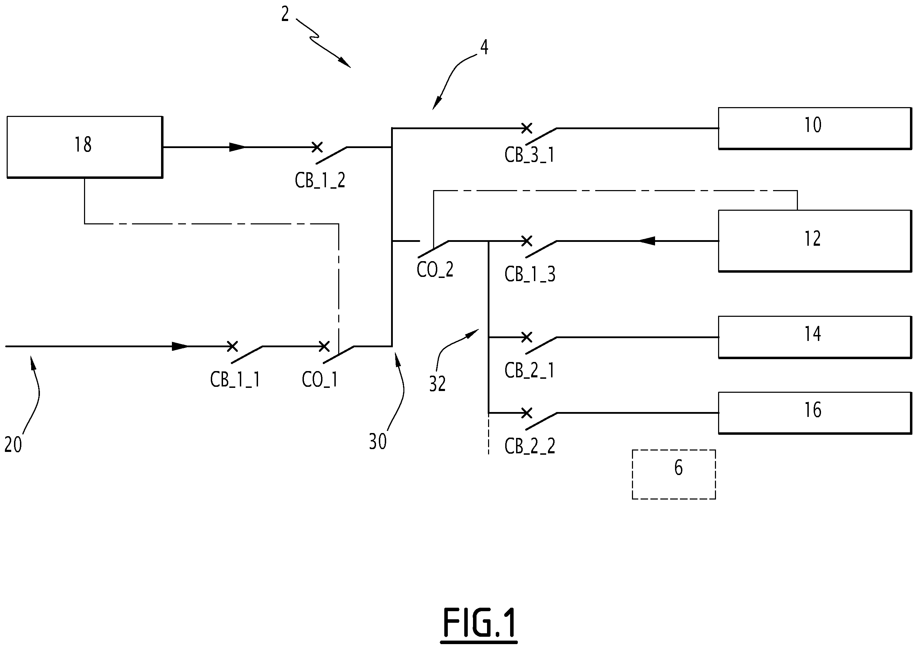

La figure 1 représente un exemple d'installation électrique 2, telle qu'une installation de distribution d'électricité dans un bâtiment ou dans un groupe de bâtiments.

L'installation électrique 2 comporte au moins une charge électrique et une source électrique comportant un convertisseur de puissance à découpage incluant un ou des interrupteurs de puissance, tels que des composants semi-conducteurs de puissance. Dans ce qui suit, cette source électrique est dite être basée sur des semi-conducteurs. L'installation comprend aussi au moins un appareil de protection et des conducteurs électriques permettant de distribuer le courant produit par la ou les sources électriques vers la ou les charges électriques.

L'installation électrique 2 est ici configurée pour distribuer un courant alternatif (AC).

Par exemple, l'installation électrique 2 est configurée pour distribuer un courant polyphasé, tel qu'un courant triphasé, pouvant ou non comporter une ligne de neutre.

De préférence, au moins l'une des sources électriques de l'installation électrique 2 est une source photovoltaïque comportant un ou plusieurs panneaux solaires connectés à un convertisseur de puissance à découpage, tel qu'un onduleur, le convertisseur de puissance comportant des composants semi conducteurs de puissance, tels que des transistors.

L'installation 2 comporte également un système de protection 4 configuré pour protéger l'installation 2 contre des défauts électriques et plus particulièrement contre des court circuits.

Le système de protection 4 comporte par exemple un ou plusieurs appareils de commutation électrique, tels que des contacteurs, et un ou plusieurs appareils de protection électrique, tels que des disjoncteurs, ainsi que des appareils de mesure capables, par exemple, de mesurer le courant électrique ou la tension électrique dans l'installation 2.

Les appareils de mesure comportent par exemple des capteurs aptes à mesurer un courant alternatif, de préférence pour chaque phase électrique et peuvent être associés aux différents appareils de protection électrique.

Le système de protection 4 comporte également un dispositif électronique de commande 6 capable de détecter un défaut électrique, tel qu'un court circuit, et de piloter au moins un appareil de protection en conséquence.

Dans certaines variantes, le dispositif électronique de commande 6 est connecté à un ou plusieurs appareils de protections.

Mais dans des modes de réalisation préférentiels, le système de protection 4 comporte plusieurs dispositifs électroniques de commande 6, chacun étant embarqué dans un appareil de protection pour piloter cet appareil de protection.

Dans de nombreux exemples, le dispositif électronique de commande 6 comporte des circuits électroniques. Par exemple, le dispositif électronique de commande 6 comporte un processeur, tel qu'un microcontrôleur programmable ou un microprocesseur. Le processeur est couplé à une mémoire informatique, ou à un support d'enregistrement de données lisible par ordinateur, qui comporte des instructions exécutables et/ou un code logiciel prévu pour mettre en oeuvre un procédé de détection d'un défaut électrique tel qu'il sera exposé dans ce qui suit, lorsque ces instructions sont exécutées par le processeur.

Selon des variantes, le dispositif électronique de commande 6 peut comporter un processeur de traitement du signal (DSP), ou un contrôleur logique programmable (PLC), ou un composant logique reprogrammable (FPGA), ou un circuit intégré spécialisé (ASIC), ou tout élément équivalent.

Dans l'exemple illustré sur la figure 1, l'installation 2 comporte une première charge électrique 10, un dispositif de stockage d'électricité 12, des deuxièmes charges électriques 14 et 16, une source électrique photovoltaïque 18 et un point de raccordement à un réseau électrique de distribution 20.

Le dispositif de stockage d'électricité 12, qui comporte par exemple au moins une batterie électrochimique (ou tout autre type de stockage d'énergie), peut fonctionner alternativement comme une charge électrique (lorsqu'il est en cours de stockage ou de maintien de l'énergie) ou comme une source électrique (lorsqu'il fournit de l'énergie pour alimenter l'installation 2). Le dispositif de stockage d'électricité 12 peut aussi être un véhicule électrique connecté à une borne de chargement reliée à l'installation 2.

Dans certaines installations, on peut distinguer les charges électriques dites critiques, qui dans la mesure du possible ne doivent pas être interrompues, de charges électriques ordinaires dites non-critiques, pour lesquelles une interruption de l'alimentation peut être tolérée dans une certaine mesure.

Par exemple, la première charge électrique 10 est une charge non critique et les deuxièmes charges électriques 14 et 16 sont des charges électriques critiques, cet exemple n'étant pas limitatif.

Les charges critiques 14 et 16 sont par exemple connectées de façon à pouvoir être facilement alimentées par le dispositif de stockage d'électricité 12 lorsque les sources 18 et 20 sont indisponibles.

Les sources 18 et 20 sont connectées à un répartiteur principal 30 lui-même connecté aux charges électriques 10 à 16.

Par exemple, la source photovoltaïque 18 est connectée au répartiteur 30 par l'intermédiaire d'un appareil de protection électrique, tel qu'un disjoncteur, noté CB_1_2. Le réseau électrique 20 est connecté au répartiteur 30 par l'intermédiaire d'un appareil de protection électrique, tel qu'un disjoncteur, noté CB_1_1, et d'un appareil de commutation CO_1, tel qu'un contacteur, qui dans cet exemple peut être piloté par la source photovoltaïque 18, par exemple pour déconnecter le réseau électrique 20 lorsque la source photovoltaïque 18 fournit suffisamment d'électricité à l'installation 2.

La première charge électrique 10 est connectée au répartiteur 30 par l'intermédiaire d'un appareil de protection électrique, tel qu'un disjoncteur, noté CB_3_1.

Les deuxièmes charges électriques 14 et 16 sont connectées à un répartiteur secondaire 32 par l'intermédiaire d'appareils de protection électrique, tel que des disjoncteurs, respectivement notés CB_2_1 et CB_2_2.

Le répartiteur secondaire 32 est ici connecté au répartiteur 30 par l'intermédiaire d'un appareil de commutation CO_2, tel qu'un contacteur, qui peut par exemple être piloté par le dispositif de stockage d'électricité 12.

L'installation 2 pourrait être construite différemment en variante, par exemple avec des charges différentes et/ou avec des sources électriques différentes et/ou posséder un nombre différent d'appareil de protection ou de commutation et/ou présenter un agencement différent.

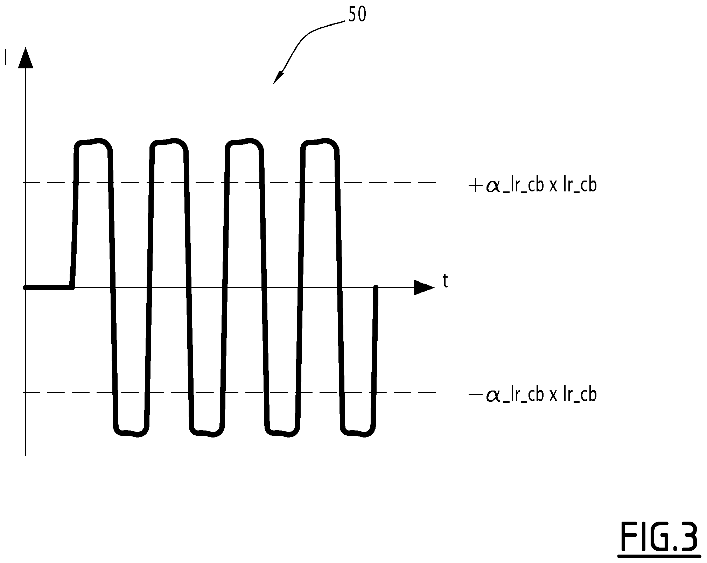

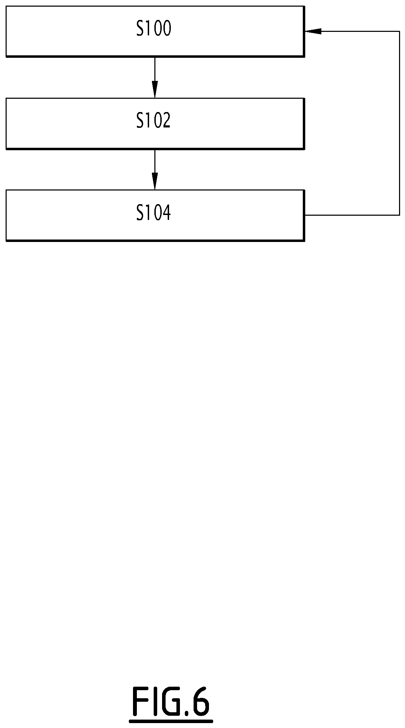

De façon générale, comme illustré en référence aux figures 3, 4 et 6, le système de protection 4 est plus particulièrement configuré pour mettre en oeuvre, pour chaque appareil de protection (tel qu'un disjoncteur) associé à une charge électrique et/ou à une source électrique de l'installation 2, un procédé comportant des étapes consistant à :
- mesurer (étape 100), par un capteur associé à un appareil électrique de protection de l'installation, un courant électrique alternatif circulant dans l'installation électrique ;
- détecter un défaut électrique (étape 102), tel qu'un court-circuit, à partir du courant électrique mesuré, par un dispositif électronique de commande (6) ;
- déclencher l'appareil de protection électrique (étape 104) lorsqu'un défaut électrique est identifié par le dispositif électronique de commande 6.

Selon des aspects de l'invention, détecter un défaut électrique comporte l'identification d'une transition du courant mesuré depuis un premier niveau vers un deuxième niveau, ladite transition ayant une durée (γ_t) inférieure à un seuil prédéfini (δ_t), le seuil prédéfini étant par exemple inférieur ou égal à 10% de la période nominale du courant électrique alternatif, le premier niveau et le deuxième niveau correspondant à des valeurs de courant de signe opposé mais dont l'amplitude, en valeur absolue, est supérieure à un seuil de courant prédéfini, le seuil de courant prédéfini étant égal au produit du seuil de déclenchement de l'appareil de protection (lr_cb) par un coefficient de pondération (α_lr_cb).

Par exemple, lors de l'étape 102, à chaque fois que le dispositif électronique de commande 6 détecte une transition depuis un premier niveau vers un deuxième niveau, le dispositif électronique de commande 6 mesure la durée de la transition (γ_t) et compare cette durée avec le seuil prédéfini (δ_t).

De préférence, le procédé est mis en oeuvre lorsque la source 18 est connectée à l'installation électrique et alimente électriquement l'installation électrique, en fournissant un courant électrique vers une ou plusieurs des charges électriques connectées à l'installation 2.

Dans certains exemples, le réseau 20 n'est pas connecté à l'installation 2 lorsque le procédé est mis en oeuvre.

En variante, les étapes pourraient être exécutées dans un ordre différent. Certaines étapes pourraient être omises. L'exemple décrit ne fait pas obstacle à ce que, dans d'autres modes de réalisation, d'autres étapes soient mises en oeuvre conjointement et/ou séquentiellement avec les étapes décrites.

### On comprend que ces étapes, notamment les étapes 100 et 102 peuvent être répétées, par exemple tant qu'aucun défaut n'est identifié

Par exemple, lors de l'étape 100, le courant électrique est mesuré continûment par les capteurs des appareils de mesure, en un ou plusieurs points de l'installation (de préférence pour chaque appareil de protection électrique). Les capteurs peuvent par exemple mesurer ou échantillonner le courant électrique de façon périodique au cours du temps.

Avantageusement, dans le cas où le courant électrique mesuré est un courant polyphasé, tel qu'un courant triphasé, alors un défaut électrique est considéré comme détecté lors de l'étape 102 si ladite transition du courant mesuré est identifiée pour au moins une phase électrique du courant mesuré.

Ce même principe de mesure et de détection est applicable à tout circuit monophasé.

La figure 3 illustre plus en détail l'une des conditions pour qu'un défaut électrique soit identifié par le procédé. Sur cet exemple, la courbe 50 représente l'évolution du courant mesuré (noté I, en ordonnées, suivant une échelle arbitraire) en fonction du temps (noté t, en abscisses, suivant une échelle arbitraire).

Sur cet exemple, le courant mesuré (trait épais) présente des alternances périodiques entre un état haut et un état bas, présentant la forme de plateaux et ayant des signes opposés. Ces états haut et bas ont par exemple une forme de plateau à cause d'une limitation du courant causée par l'action d'une protection de la source électrique. Toutefois, en variante, le courant mesuré pourrait présenter une forme différente. Il pourrait par exemple s'agir d'un maxima et d'un minima, respectivement, dans le cas d'un signal de courant de forme sinusoïdale.

Les traits en pointillés délimitent un premier niveau (+α_lr_cb x lr_cb) et un deuxième niveau (-α_lr_cb x lr_cb).

Le deuxième niveau (-α_lr_cb x lr_cb) correspond, en valeur absolue, à une amplitude équivalente que le premier niveau (+α_lr_cb x lr_cb), mais présente un signe opposé (ici, un signe négatif).

Le premier niveau et le deuxième niveau sont donc, en valeur absolue, tous deux équivalents au seuil de courant prédéfini (α_lr_cb x lr_cb).

La transition que vise à détecter le défaut correspond à une transition entre une valeur supérieure au premier niveau et une valeur inférieure au deuxième niveau.

Autrement dit, une condition pour que la transition soit détectée, est que le courant passe d'une valeur d'intensité (d'amplitude) supérieure au premier niveau vers une amplitude inférieure au deuxième niveau (ou inversement, depuis le deuxième niveau vers le premier niveau).

En d'autres termes, une variation du courant ne sera pas considérée comme une telle transition si elle se fait entre des valeurs dont l'amplitude est inférieure en valeur absolue audit seuil de courant prédéfini.

Comme expliqué ci-dessus, le seuil de courant prédéfini étant égal au produit du seuil de déclenchement de l'appareil de protection (Ir_cb) par un coefficient de pondération (α_lr_cb).

Le seuil de déclenchement de l'appareil de protection (lr_cb) correspond par exemple à une valeur du courant de réglage (Ir) de l'appareil de protection (s'il est de nature réglable) ou à son courant nominal (s'il ne possède pas de réglage).

Avantageusement, le coefficient de pondération (α_lr_cb) est supérieur à 1.

Par exemple, le coefficient de pondération (α_lr_cb) est compris entre 1 et 5.

D'autres valeurs sont possibles en variante.

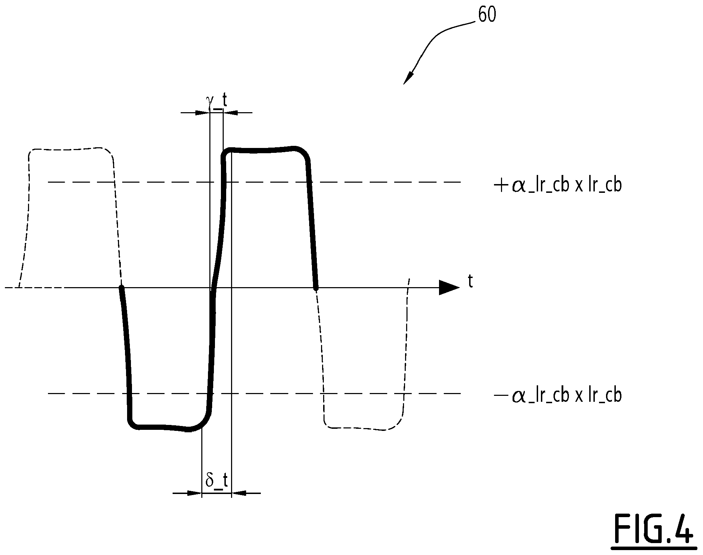

La figure 4 illustre plus en détail une autre condition pour qu'un défaut électrique soit identifié par le procédé. Sur cet exemple, la courbe 60 représente l'évolution du courant mesuré (en ordonnées, suivant une échelle arbitraire) en fonction du temps (noté t, en abscisses, suivant une échelle arbitraire).

Les traits en pointillés délimitent, comme précédemment, le premier niveau (+α_lr_cb x Ir_cb) et le deuxième niveau (-α_lr_cb x lr_cb).

Dans cet exemple, comme précédemment, le courant mesuré présente des alternances périodiques entre un état haut et un état bas ayant des signes opposés (un étant positif et un état négatif, ayant ici des formes de plateaux), et présente une transition plus rapide que les autres transitions.

Sur la figure 4 sont illustrées la durée de la transition (γ_t) et le seuil prédéfini (δ_t).

Par exemple, la valeur du seuil prédéfini (δ_t) dépend de caractéristiques du convertisseur de puissance à découpage constituant ladite source électrique, telles que la périodicité nominale du courant mesuré (qui dépend de la fréquence de découpage du convertisseur de puissance) et de la vitesse de variation maximale du courant permise par les selfs de découpage (inductances, ou « switching choke » en anglais) du convertisseur de puissance (ou de tout autre élément limitant la vitesse d'évolution du courant).

De préférence, le seuil prédéfini (δ_t) étant par exemple inférieur ou égal à 10% de la période nominale du courant électrique.

Selon un exemple donné à des fins d'illustration, pour un convertisseur de puissance fonctionnant avec une fréquence de découpage de 10 kHz, le seuil prédéfini (δ_t) peut être égal à 2 millisecondes (ms).

Autrement dit, une deuxième condition pour que la transition soit détectée, est que ladite transition ayant une durée (γ_t) inférieure à un seuil prédéfini (δ_t).

Grâce à l'invention, on peut détecter facilement et avec un bon niveau de fiabilité des défauts électriques, tels que des court circuits, dans une installation alimentée par une source électrique basée sur un convertisseur de puissance à découpage tel qu'un onduleur.

Plutôt que de fonder la détection uniquement sur la détection d'une intensité anormalement élevée, le système de protection 4 identifie un défaut électrique, notamment un court-circuit, en identifiant une vitesse de transition anormalement rapide entre un état haut et un état bas ayant une certaine amplitude.

Il est donc plus facile de détecter un défaut électrique de type court circuit lorsqu'une source électrique comportant (ou étant associée à) un convertisseur de puissance à découpage est active dans l'installation électrique, sans pour autant avoir à abaisser les seuils de déclenchement de tous les appareils de protection. Ainsi, on peut augmenter les seuils de courant utilisables par les charges électriques et ainsi utiliser plus efficacement l'installation électrique 2.

Selon des modes de réalisation particulièrement avantageux, lors de l'étape 102, le défaut électrique n'est détecté que si, en plus, ladite transition du courant mesurée est identifiée comme se répétant pour une ou plusieurs périodes du courant alternatif mesuré, sur une durée supérieure ou égale à une durée prédéfinie (Load_Tr).

Avantageusement, la durée prédéfinie (Load_Tr) est par exemple supérieure ou égale à trois fois la période nominale du courant électrique alternatif.

Par exemple, la période nominale du courant mesuré est la période du courant alternatif délivré par le convertisseur de puissance associé à ladite source électrique.

Selon un exemple donné à des fins d'illustration, la durée prédéfinie (Load_Tr) est égale à 40 millisecondes (ms).

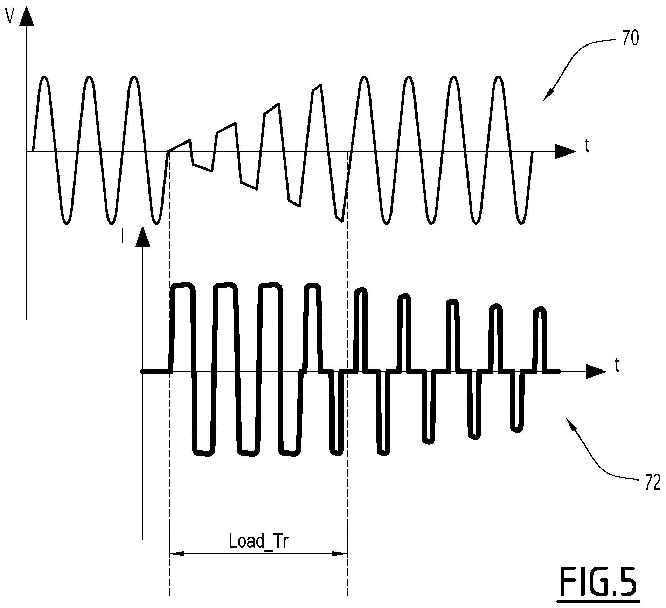

La figure 5 illustre un exemple de modification de la tension électrique et du courant électrique dans l'installation causée par un effet transitoire non-linéaire.

Un tel effet transitoire non-linéaire peut être causé par la charge électrique surveillée par l'appareils de protection, par exemple au moment de connexion de la charge à l'installation électrique.

Sur cette figure, la courbe 70 illustre l'évolution de la tension électrique (notée « V », en ordonnées, suivant une échelle arbitraire) en fonction du temps (noté t, en abscisses, suivant une échelle arbitraire).

La courbe 72 illustre l'évolution du courant électrique (noté « I », en ordonnées, suivant une échelle arbitraire) en fonction du temps (noté t, en abscisses, suivant une échelle arbitraire).

Sur cet exemple, à partir d'un premier instant, le courant électrique subit des transitions rapides entre un premier état et un deuxième état de signe opposé. En parallèle, la tension électrique, qui jusqu'alors évoluait périodiquement avec une forme sinusoïdale, subit une brutale chute de tension.

Ensuite, après une durée sur cet exemple correspondant à trois périodes nominales du courant, la durée des transitions augmente tandis que l'amplitude maximale (en valeur absolue) atteinte par le courant électrique à chaque alternance diminue graduellement. En parallèle, la tension augmente à nouveau jusqu'à reprendre une forme d'onde normale, telle que potentiellement la forme sinusoïdale qu'elle avait à l'origine.

Un tel phénomène ne correspond pas à un défaut électrique de court circuit, mais plutôt à un phénomène transitoire lié au comportement d'une charge (par exemple la connexion d'une charge électrique) et ne doit donc à priori pas conduire au déclenchement de l'appareil de protection situé juste en amont.

La durée prédéterminée Load_Tr permet d'attendre suffisamment longtemps pour s'assurer que la variation du courant électrique est causée uniquement par un phénomène transitoire.

La prise en compte de cette durée prédéterminée Load_Tr permet d'éviter de faire déclencher intempestivement l'appareil de protection à cause d'un simple phénomène transitoire. Cela rend le procédé de détection plus fiable.

La prise en compte de cette durée prédéterminée Load_Tr permet également d'éviter de déclencher intempestivement l'appareil de protection en cas d'un courant de surcharge provenant du réseau 20. Dans ce cas, l'appareil de protection sera tout de même déclenché, mais par le déclencheur habituel plutôt que par le présent procédé. Autrement dit, le procédé n'empêche pas les moyens de protection classiques de fonctionner.

De préférence encore, lorsque le procédé attend pendant la durée prédéterminée Load_Tr, il est préférable que la première condition et la deuxième condition soient remplies pour chaque alternance pendant cette durée. Cela permet de rendre le procédé de détection plus robuste et moins sensible à des phénomènes transitoires.

En effet, il peut arriver que, dans le cas d'un phénomène transitoire, la condition sur la vitesse de transition (critère sur la durée γ_t) soit satisfaite pour la première transition mais pas pour les suivantes.

Autrement dit, de préférence, une troisième condition pour que la transition soit détectée, est que les première et deuxième conditions soient remplies pour plusieurs transitions du courant mesuré, ces transitions étant répétées pendant une durée suffisamment longue (la durée prédéterminée Load_Tr).

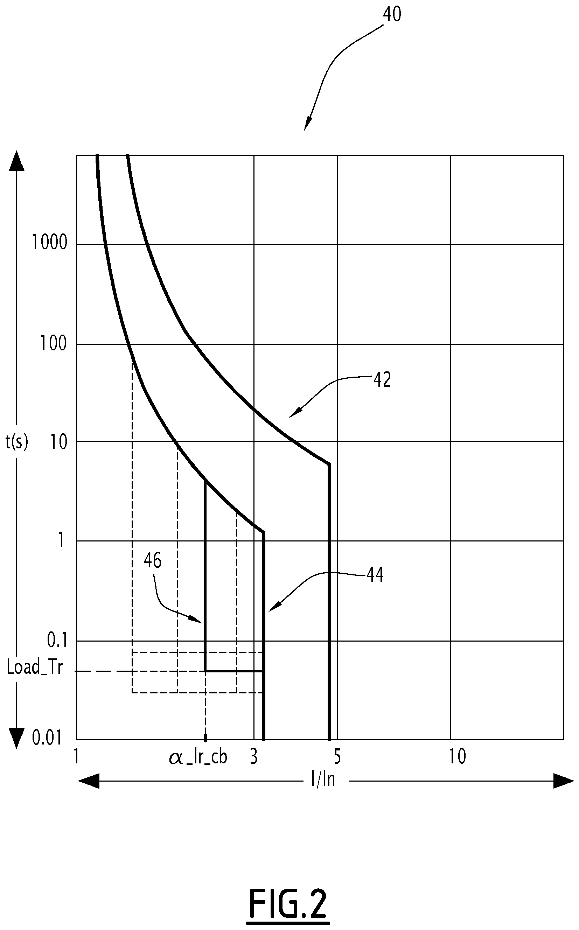

La figure 2 représente schématiquement un exemple 40 de deux courbes de déclenchement associées à des appareils de protection électrique, tels que des disjoncteurs.

Sur ces deux courbes, l'axe des ordonnées correspond à l'axe des temps (noté t(s)) exprimé sur une échelle logarithmique, tandis que l'axe des abscisses correspond au rapport du courant sur le courant nominal (In) de l'appareil de protection.

Les courbes de déclenchement 42 et 44 correspondent aux courbes maximum et minimum de déclenchement classique. La première partie de ces courbes de déclenchement (ici pour les temps supérieurs à quelques secondes) correspond aux défauts « longs » tels que des courants de surcharge, tandis que la deuxième partie de la courbe (ici pour les temps inférieurs à quelques secondes) correspond aux défauts « courts » tels que les court circuits.

La courbe de déclenchement 46 correspond à une courbe améliorée d'un appareil de protection de l'installation 2 pour lequel le procédé précédemment décrit est mis en oeuvre. Dans l'exemple illustré, la courbe de déclenchement 46 est en partie identique à la courbe de déclenchement classique minimum 44. La courbe de déclenchement 46 comporte une portion de courbe de déclenchement supplémentaire (illustrée en trait fin) qui illustre l'effet du procédé de détection précédemment décrit et qui est ici différente de la courbe de déclenchement classique minimum 44.

Notamment, les défauts électriques rapides (tels que des court circuits) peuvent être détectés plus facilement, pour un seuil de déclenchement (α_lr_cb x lr_cb) plus sensible que le seuil de courant (lr_cb) réglé sur les appareils de protection.

Lorsque les conditions pour détecter le court circuit selon le procédé ne sont pas remplies (la première condition et la deuxième condition précédemment décrite, voire la troisième condition), alors les conditions usuelles de déclenchement (matérialisées par les courbes de déclenchement classiques 42 et 44) s'appliquent.

Les modes de réalisation et les variantes envisagés ci-dessus peuvent être combinés entre eux pour créer de nouveaux modes de réalisation.

## Revendications

1. Procédé pour détecter un défaut électrique dans une installation électrique (2), ladite installation électrique comportant une source électrique basée sur un convertisseur de puissance à découpage, le procédé comportant des étapes consistant à :
• mesurer (100), par un capteur associé à un appareil électrique de protection de l'installation, un courant électrique alternatif circulant dans l'installation électrique ;
• détecter un défaut électrique (102), tel qu'un court-circuit, à partir du courant électrique mesuré, par un dispositif électronique de commande (6) ;
• déclencher l'appareil de protection électrique (104) lorsqu'un défaut électrique est identifié par le dispositif électronique de commande (6) ;
**caractérisé par le fait que**,
dans lequel détecter un défaut électrique (102) comporte l'identification d'une transition du courant mesuré depuis un premier niveau vers un deuxième niveau, ladite transition ayant une durée (γ_t) inférieure à un seuil prédéfini (δ_t),le seuil prédéfini étant inférieur ou égal à 10% de la période nominale du courant électrique alternatif, le premier niveau et le deuxième niveau correspondant à des valeurs de courant de signe opposé mais dont l'amplitude, en valeur absolue, est supérieure à un seuil de courant prédéfini, le seuil de courant prédéfini étant égal au produit du seuil de déclenchement de l'appareil de protection (Ir_cb) par un coefficient de pondération (α_lr_cb).

2. Procédé selon la revendication 1, dans lequel le défaut électrique (102) n'est détecté que si, en plus, ladite transition du courant mesurée est identifiée comme se répétant sur une ou plusieurs périodes du courant alternatif mesuré, sur une durée supérieure ou égale à une durée prédéfinie (Load_Tr).

3. Procédé selon la revendication 2, dans lequel la durée prédéfinie (Load_Tr) est supérieure ou égale à trois fois la période nominale du courant électrique alternatif.

4. Procédé selon l'une quelconque des revendications précédentes, dans lequel le coefficient de pondération (α_lr_cb) est supérieur à 1.

5. Procédé selon la revendication précédente, dans lequel le coefficient de pondération (α_lr_cb) est compris entre 1 et 5.

6. Procédé selon l'une quelconque des revendications précédentes, dans lequel le courant électrique mesuré est un courant monophasé ou polyphasé, tel qu'un courant triphasé, et dans lequel un défaut électrique est considéré comme détecté (102) si ladite transition du courant mesuré est identifiée pour au moins une phase électrique du courant mesuré.

7. Système de protection (4) pour protéger une installation électrique (2) comportant une source électrique basée sur un convertisseur de puissance à découpage, le système de protection comportant au moins un appareil de protection électrique et un dispositif électronique de commande (6) programmé pour :
• mesurer (100), par un capteur associé à un appareil de protection électrique de l'installation, un courant électrique alternatif circulant dans l'installation électrique ;
• détecter un défaut électrique (102), tel qu'un court-circuit, à partir du courant électrique mesuré ;
• déclencher l'appareil de protection électrique (104) lorsqu'un défaut électrique est identifié ;
**caractérisé par le fait que**,
dans lequel détecter un défaut électrique (102) comporte l'identification d'une transition du courant mesuré depuis un premier niveau vers un deuxième niveau, ladite transition ayant une durée (γ_t) inférieure à un seuil prédéfini (δ_t),le seuil prédéfini étant inférieur ou égal à 10% de la période nominale du courant électrique alternatif, le premier niveau et le deuxième niveau correspondant à des valeurs de courant de signe opposé mais dont l'amplitude, en valeur absolue, est supérieure à un seuil de courant prédéfini, le seuil de courant prédéfini étant égal au produit du seuil de déclenchement de l'appareil de protection (Ir_cb) par un coefficient de pondération (α_lr_cb).

8. Système selon la revendication 7, dans lequel un dispositif électronique de commande (6) est associé à chaque appareil de protection électrique.

9. Système selon la revendication 7, dans lequel le dispositif électronique de commande (6) est connecté à chaque appareil de protection électrique.

## Patentansprüche

1. Verfahren zum Erkennen eines elektrischen Fehlers in einer elektrischen Anlage (2), wobei die elektrische Anlage eine elektrische Quelle basierend auf einem Schaltleistungswandlers umfasst, das Verfahren umfassend Schritte, die aus Folgendem bestehen:
• Messen (100), durch einen Sensor, der mit einem elektrischen Schutzgerät der Anlage verbunden ist, eines in der elektrischen Anlage fließenden elektrischen Wechselstroms;
• Erkennen eines elektrischen Fehlers (102), wie beispielsweise eines Kurzschlusses, anhand des gemessenen elektrischen Stroms durch eine elektronische Steuervorrichtung (6);
• Auslösen des elektrischen Schutzgeräts (104), wenn von der elektronischen Steuervorrichtung (6) ein elektrischer Fehler erkannt wird;
**gekennzeichnet durch** den Umstand, dass
wobei das Erfassen eines elektrischen Fehlers (102) das Identifizieren eines Übergangs des gemessenen Stroms von einem ersten Pegel zu einem zweiten Pegel umfasst, wobei der Übergang eine Dauer (γ_t) aufweist, die kleiner ist als ein vordefinierter Schwellenwert (δ_t), wobei der vordefinierte Schwellenwert kleiner als oder gleich wie 10 % der Nennperiode des elektrischen Wechselstroms ist, wobei der erste Pegel und der zweite Pegel Stromwerten mit entgegengesetztem Vorzeichen entsprechen, deren Amplitude als Absolutwert jedoch größer ist als ein vordefinierter Stromschwellenwert, wobei der vordefinierte Stromschwellenwert gleich wie das Produkt aus dem Auslöseschwellenwert des Schutzgeräts (lr_cb) und einem Gewichtungskoeffizienten (α_lr_cb) ist.

2. Verfahren nach Anspruch 1, wobei der elektrische Fehler (102) nur dann erkannt wird, wenn zusätzlich der gemessene Stromübergang über eine Dauer, die größer als oder gleich wie eine vordefinierte Dauer (Load_Tr) ist, als sich über eine oder mehrere Perioden des gemessenen Wechselstroms wiederholend identifiziert wird.

3. Verfahren nach Anspruch 2, wobei die vordefinierte Dauer (Load_Tr) größer als oder gleich wie das Dreifache der Nennperiode des elektrischen Wechselstroms ist.

4. Verfahren nach einem der vorherigen Ansprüche, wobei der Gewichtungskoeffizient (α_lr_cb) größer als 1 ist.

5. Verfahren nach dem vorherigen Anspruch, wobei der Gewichtungsfaktor (α_lr_cb) zwischen 1 und 5 ist.

6. Verfahren nach einem der vorherigen Ansprüche, wobei der gemessene elektrische Strom ein einphasiger oder mehrphasiger Strom ist, wie beispielsweise ein dreiphasiger Strom, und wobei ein elektrischer Fehler als erkannt (102) gilt, wenn der Übergang des gemessenen Stroms für mindestens eine elektrische Phase des gemessenen Stroms identifiziert wird.

7. Schutzsystem (4) zum Schutz einer elektrischen Anlage (2) mit einer auf einem Schaltleistungswandler basierenden Stromquelle, wobei das Schutzsystem mindestens ein elektrisches Schutzgerät und eine elektronische Steuervorrichtung (6) umfasst, die zu Folgendem programmiert ist:
• Messen (100), durch einen Sensor, der mit einem elektrischen Schutzgerät der Anlage verbunden ist, eines in der elektrischen Anlage fließenden elektrischen Wechselstroms;
• Erkennen eines elektrischen Fehlers (102), wie beispielsweise eines Kurzschlusses, anhand des gemessenen elektrischen Stroms;
• Auslösen des elektrischen Schutzgeräts (104), wenn ein elektrischer Fehler erkannt wird;
**gekennzeichnet durch** den Umstand, dass
wobei das Erfassen eines elektrischen Fehlers (102) das Identifizieren eines Übergangs des gemessenen Stroms von einem ersten Pegel zu einem zweiten Pegel umfasst, wobei der Übergang eine Dauer (γ_t) aufweist, die kleiner ist als ein vordefinierter Schwellenwert (δ_t), wobei der vordefinierte Schwellenwert kleiner als oder gleich wie 10 % der Nennperiode des elektrischen Wechselstroms ist, wobei der erste Pegel und der zweite Pegel Stromwerten mit entgegengesetztem Vorzeichen entsprechen, deren Amplitude als Absolutwert jedoch größer ist als ein vordefinierter Stromschwellenwert, wobei der vordefinierte Stromschwellenwert gleich wie das Produkt aus dem Auslöseschwellenwert des Schutzgeräts (lr_cb) und einem Gewichtungskoeffizienten (α_lr_cb) ist.

8. System nach Anspruch 7, wobei mit jedem elektrischen Schutzgerät eine elektronische Steuervorrichtung (6) assoziiert ist.

9. System nach Anspruch 7, wobei die elektronische Steuervorrichtung (6) mit jedem elektrischen Schutzgerät verbunden ist.

## Claims

1. A method of detecting an electrical fault in an electrical installation (2), said electrical installation including an electrical source based on a switching power converter, the method comprising steps consisting of:
• measuring (100), by means of a sensor associated with an electrical installation protection device, an alternating electrical current flowing in the electrical installation;
• detecting an electrical fault (102), such as a short-circuit, on the basis of the measured electrical current, by an electronic control device (6);
• tripping the electrical protection device (104) when an electrical fault is identified by the electronic control device (6);
**characterised by** the fact that,
wherein detecting an electrical fault (102) comprises identifying a transition of the measured current from a first level to a second level, said transition having a duration (γ_t) less than a predefined threshold (δ_t), the predefined threshold being less than or equal to 10% of the nominal period of the alternating electrical current, the first level and the second level corresponding to current values of opposite sign but whose amplitude, in absolute value, is greater than a predefined current threshold, the predefined current threshold being equal to the product of the trip threshold of the protection device (lr_cb) and a weighting coefficient (α_lr_cb).

2. A method according to claim 1, wherein the electrical fault (102) is detected only if, in addition, said measured current transition is identified as repeating over one or more periods of the measured alternating current, over a duration greater than or equal to a predefined duration (Load_Tr).

3. A method according to claim 2, wherein the predefined duration (Load_Tr) is greater than or equal to three times the nominal period of the alternating electric current.

4. A method according to any one of the preceding claims, wherein the weighting coefficient (α_lr_cb) is greater than 1.

5. A method according to the preceding claim, in which the weighting coefficient (α_lr_cb) is between 1 and 5.

6. A method according to any one of the preceding claims, in which the measured electrical current is a single-phase or polyphase current, such as a three-phase currentand in which an electrical fault is considered to be detected (102) if said transition of the measured current is identified for at least one electrical phase of the measured current.

7. A protection system (4) for protecting an electrical installation (2) comprising an electrical source based on a switching power converter, the protection system comprising at least one electrical protection device and an electronic control device (6) programmed to:
• measuring (100), by means of a sensor associated with an electrical protection device of the installation, an alternating electrical current flowing in the electrical installation;
• detecting an electrical fault (102), such as a short-circuit, from the measured electrical current;
• tripping the electrical protection device (104) when an electrical fault is identified;
**characterised by** the fact that,
wherein detecting an electrical fault (102) comprises identifying a transition of the measured current from a first level to a second level, said transition having a duration (γ_t) less than a predefined threshold (δ_t), the predefined threshold being less than or equal to 10% of the nominal period of the alternating electrical current, the first level and the second level corresponding to current values of opposite sign but whose amplitude, in absolute value, is greater than a predefined current threshold, the predefined current threshold being equal to the product of the trip threshold of the protection device (lr_cb) and a weighting coefficient (α_lr_cb).

8. A system according to claim 7, in which an electronic control device (6) is associated with each electrical protection device.

9. A system as claimed in claim 7, wherein the electronic control device (6) is connected to each electrical protection device.
